# EUROPEAN PATENT SPECIFICATION

(11) **EP 4 079 411 B1**
(45) Date of publication and mention of the grant of the patent: **05.11.2025**
(21) Application number: 21918120.3
(22) Date of filing: 31.12.2021
(51) Int. Cl.: B05B 7/22, C23C 16/513, C23C 4/134

(54) **SPRAY NOZZLE APPARATUS**
SPRÜHDÜSENVORRICHTUNG
APPAREIL À BUSE DE PULVÉRISATION

(30) Priority: 08.03.2021 KR 20210030043
(43) Date of publication of application: 26.10.2022
(73) Proprietor: Applied Plasma Inc., Gumi-si Gyeongsangbuk-do 39422 (KR)
(72) Inventor: PARK, Jae Beom, Daegu 42752 (KR); CHOI, In Ho, Gyeongsangbuk-do 39459 (KR)
(74) Representative: Bernsmann, Falk
(86) International application number: PCT/KR2021/020351
(87) International publication number: WO 2022/191393

(56) References cited:
- CA-A1- 2 143 907
- JP-A- 2012 015 180
- JP-A- 2016 163 034
- KR-A- 20140 108 165
- KR-A- 20170 014 983
- KR-A- 20170 014 983
- KR-A- 20180 014 108
- KR-B1- 100 930 579

## Description

### [Technical Field]

The present invention relates to a spray nozzle device, and more particularly, to a spray nozzle device for improving a mixing rate with plasma by rotating a deposition material.

### [Background Art]

For decades, plasma has been applied to various fields such as semiconductor industry, display industry, and surface modification of materials. Since these industrial plasma apparatuses perform a process in a vacuum state, the apparatuses are expensive and not suitable for use in producing low-cost products. As plasma technology is gradually developed, research for generating plasma not in a vacuum state but in an atmospheric pressure state is being conducted.

The plasma may ionize deposition materials such as precursors, and the deposition materials ionized by the plasma may be easily deposited on a product surface. The ionized deposition materials may be deposited on the product surface, thereby forming a coating layer on the product surface. However, since the deposition materials or the like are not supplied to be evenly distributed in a reaction space for the plasma and the deposition material, the thickness of the coating layer formed on the product surface is not even, and thus powder is formed, and the amount of the deposition materials used increases. Document KR 10-2017-0017983 A discloses a nozzle comprising a body in which a liquid discharge line having liquid flowing therein and a gas discharge line surrounding the liquid discharge line and having gas flowing therein are formed.

### [Disclosure]

### [Technical Problem]

The present invention is directed to providing a spray nozzle device for improving a mixing rate of a fluid that is a deposition material and plasma.

The present invention is also directed to providing a spray nozzle device for suppressing generation of powder generated inside a nozzle due to a gas that is a deposition material.

The present invention is also directed to providing a spray nozzle device for improving a mixing rate of a deposition material and plasma so that the thickness of a coating layer of a product is uniform.

The aspects of the present invention are not limited to the aspects described above, and those skilled in the art will clearly understand other aspects not described from the following description.

### [Technical Solution]

The present invention provides a spray nozzle device according to claim 1.

The specific details of embodiments are included in the detailed description and the drawings.

### [Advantageous Effects]

According to embodiments of the present invention, a mixing rate of plasma can be improved by rotating a deposition material. Accordingly, the deposition material sprayed in an ionized state may form a coating layer having a uniform thickness on a product surface. Further, the generation of powder generated inside a nozzle can be suppressed due to a gas that is the deposition material.

Further, the present invention can be applied to an optical coating field because a coating layer having a uniform thickness is formed on a product, and can reduce unreacted coating materials, thereby improving productivity and reducing process contamination.

The effects of the present invention are not limited to the effects described above, and those skilled in the art will clearly understand other effects not described from the appended claims.

### [Description of Drawings]

FIG. 1 is perspective view illustrating a spray nozzle device according to an embodiment of the present invention.
FIG. 2 is a block diagram illustrating the spray nozzle device of FIG. 1.
FIG. 3 is a cross-sectional view illustrating a part of the spray nozzle device of FIG. 1.
FIG. 4 is a perspective view illustrating a distribution part of FIG. 1.
FIGS. 5 to 7 are schematic views illustrating distribution parts according to other embodiments of the present invention.
FIG. 8 is a schematic view for describing a state in which a deposition gas is sprayed from the spray nozzle according to an embodiment of the present invention.

### [Modes of the Invention]

Advantages and features of the present invention and a method of achieving the advantages and the features will become apparent with reference to embodiments described below in detail together with the accompanying drawings. However, the present invention is not limited to the embodiments described below but may be implemented in various forms, and the present embodiments merely make the disclosure of the present invention complete and are provided to completely inform the scope of the present invention to those skilled in the art to which the present invention belongs, and the present invention is merely defined by the scope of the appended claims. Throughout the specification, the same reference numerals refer to the same components.

Embodiments described herein will be described with reference to cross-sectional views and/or plan views which are ideal illustrative views of the present invention. In the drawings, the thicknesses of films and regions are exaggerated for effective description of technical contents. Thus, the regions illustrated in the drawings have schematic properties, and the shapes of the regions illustrated in the drawings are intended to illustrate specific shapes of regions of elements and not to limit the scope of the present invention. In various embodiments of the present specification, terms such as first, second, third, and the like are used to describe various components, but these components should not be limited by these terms. These terms are merely used to distinguish any component from another component. The embodiments described and illustrated therein also include complementary embodiments thereof.

Terms used herein are intended to describe the embodiments and are not intended to limit the present invention. In the present specification, a singular form also includes a plural form unless specifically mentioned in a phrase. The term "comprise" or "comprising" used herein does not exclude the presence or addition of one or more other components, steps, operations, and/or to components, steps, operations, and/or elements in or to components, steps, operations, and/or elements mentioned above.

Unless otherwise defined, all the terms (including technical and scientific terms) used herein may be used as meanings that may be commonly understood by those skilled in the art to which the present invention belongs. Further, terms defined in a commonly used dictionary are not interpreted ideally or excessively unless explicitly and specifically defined.

Hereinafter, the concept of the present invention and embodiments therefor will be described in detail with reference to the accompanying drawings.

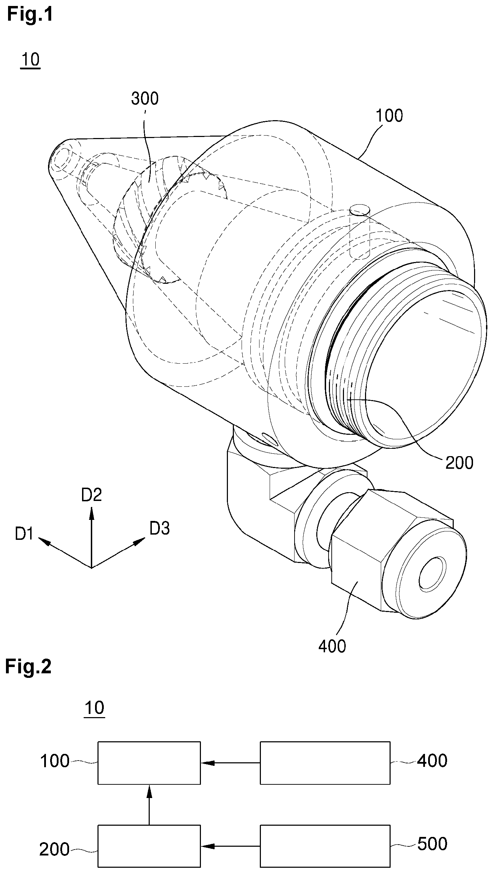

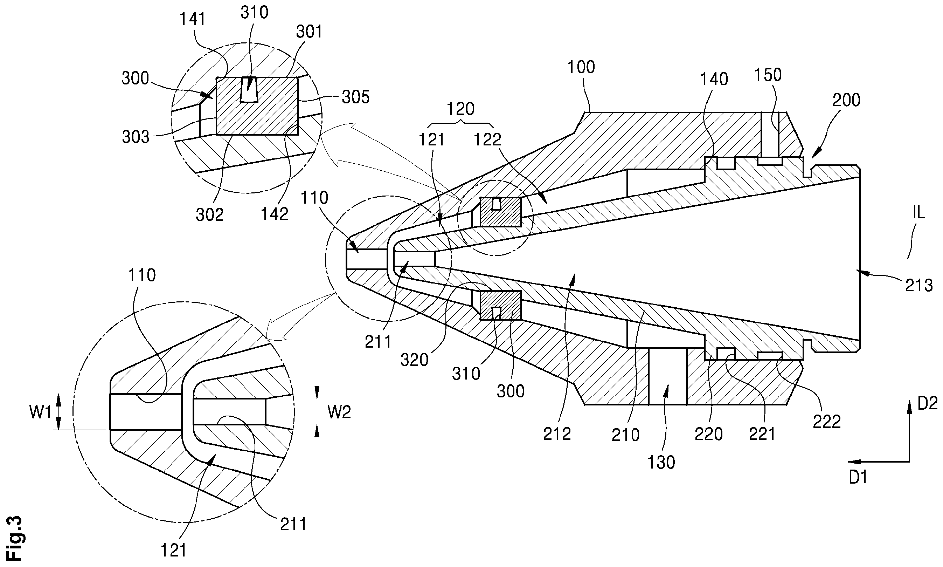

FIG. 1 is perspective view illustrating a spray nozzle device according to an embodiment of the present invention. FIG. 2 is a block diagram illustrating the spray nozzle device of FIG. 1. FIG. 3 is a cross-sectional view illustrating a part of the spray nozzle device of FIG. 1.

Referring to FIGS. 1 to 3, a spray nozzle device 10 according to the embodiment of the present invention may spray both of a fluid and a plasma. Accordingly, components contained in the fluid may be sprayed onto a product surface to be coated or deposited in an ionized state. In the embodiment, the fluid may be a gas (hereinafter, referred to as a deposition gas). Unlike this, in another embodiment, the fluid may be a liquid, a material in a supercritical state having characteristics of a liquid and a gas, or the like.

The spray nozzle device 10 includes a first nozzle unit 100, a second nozzle unit 200, and a distribution unit 300. The spray nozzle device 10 may further include a fluid supply unit 400 and a plasma supply unit 500.

The first nozzle unit 100 may spray both of the fluid and the plasma. The first nozzle unit 100 may be connected to the fluid supply unit 400. The first nozzle unit 100 includes a first spray port 110, a first internal passage 120, and a first injection port 130. The first nozzle unit 100 may include a first support step 141, a coupling step 140, at least one coupling hole 150, and an insertion port (unsigned).

The first spray port 110 may be located at one end of the first nozzle unit 100. The first spray port 110 may be formed in a first direction D1. In the embodiment, the first spray port 110 may have a circular cross-sectional shape having a first diameter W1 of a constant size in the first direction D1. The fluid may be sprayed to the outside of the first nozzle unit 100 through the first spray port 110.

The insertion port may be an inlet through which the second nozzle unit 200 is inserted into the first internal passage 120. The insertion port may be located at the other end of the first nozzle unit 100. The insertion port may be spaced apart from the first spray port 110. In the embodiment, the first spray port 110 may be spaced apart from the insertion port in the first direction D1. The insertion port may have a diameter greater than the first spray port 110.

The first internal passage 120 may be located inside the first nozzle unit 100. The first internal passage 120 may be connected to the first spray port 110, the insertion port, and the first injection port 130. Accordingly, the first spray port 110, the insertion port, and the first injection port 130 may be connected through the first internal passage 120. In the present specification, the connection may mean a state in which certain components are directly or indirectly connected.

The first internal passage 120 may extend from the insertion port toward the first spray port 110. Accordingly, the first internal passage 120 may be formed to extend in the first direction D1. The first internal passage 120 may have a circular cross-sectional shape of which the diameter is reduced as the first internal passage 120 goes closer to the first spray port 110.

The first injection port 130 may be connected to the first internal passage 120. The first injection port 130 may be connected to the fluid supply unit 400. Accordingly, a fluid supplied from the fluid supply unit 400 may be injected into the first internal passage 120 through the first injection port 130. The first injection port 130 may be located between the insertion port and the first spray port 110. In the embodiment, the first injection port 130 may be closer to the insertion hole than the first spray port 110. A screw line may be formed in a side surface of the first injection port 130.

The coupling step 140 may support a catching part 220 of the second nozzle unit 200 which will be described below. Accordingly, the coupling step 140 can prevent the second nozzle unit 200 from being inserted into the first internal passage 120 and coming into contact with the first spray port 110. In the embodiment, the width of the coupling step 140 may be substantially the same as the width of the insertion port. The width of the first internal passage 120 located between the coupling step 140 and the first spray port 110 may be smaller than the width of the coupling step 140. Accordingly, the catching part 220 supported by the coupling step 140 may not move in the first direction D1.

The coupling hole 150 may be a hole into which a coupling member (not illustrated) such as a bolt is inserted. The coupling hole 150 may connect the outside of the first nozzle unit 100 and the first internal passage 120. In the embodiment, the coupling hole 150 may be formed to extend in a second direction D2 perpendicular to the first direction D1. In the embodiment, the coupling member may be a bolt. Accordingly, a screw line may be formed in a side wall surrounding to the coupling hole 150. The first nozzle unit 100 may include a plurality of coupling holes 150. In the embodiment, the coupling holes 150 may be arranged at regular intervals along a circumference of the first nozzle unit 100.

The first support step 141 may be formed in a step shape recessed from an inner surface toward an outer surface of the first nozzle unit 100. The first support step 141 may be formed to correspond to a second support step 142 of the second nozzle unit 200 which will be described below. The first support step 141 may support a first surface 303 of the distribution unit 300. Accordingly, the first support step 141 can prevent the distribution unit 300 from moving toward the first spray port 110.

The second nozzle unit 200 may spray the plasma. The second nozzle unit 200 may be connected to the plasma supply unit 500. The second nozzle unit 200 may be located inside the first internal passage 120. In the embodiment, a portion of the second nozzle unit 200 may be located inside the first internal passage 120, but the present invention is not limited thereto. The second nozzle unit 200 may include a body part 210 and the catching part 220. The second nozzle unit 200 may include a second support step 142.

The body part 210 may form an outer shape of the second nozzle unit 200. The body part 210 may be formed to extend in the first direction D1. The body part 210 may include a second spray port 211 from which the plasma is sprayed, a second injection port 213 into which the plasma is injected, and a second internal passage 212.

The second spray port 211 may be located on one side of the second nozzle unit 200 adjacent to the first spray port 110. In the embodiment, the second spray port 211 may be located at one end of the body part 210. The second spray port 211 may be spaced apart from the first spray port 110. The second spray port 211 is located on the same virtual line as the first spray port 110. Accordingly, the plasma sprayed from the second spray port 211 may be sprayed into the first spray port 110 while ionizing the deposition gas between the first spray port 110 and the second spray port 211. In the embodiment, the same virtual line may be parallel to the first direction D1, but the present invention is not limited thereto.

The second spray port 211 may be formed in a first direction D1. In the embodiment, the second spray port 211 may have a circular cross-sectional shape having a second diameter W2 of a constant size in the first direction D1. The second diameter W2 may be smaller than the first diameter W1.

The second injection port 213 may be located at the other end of the body part 210. The second injection port 213 may be connected to the plasma supply unit 500. The diameter of the second injection port 213 may be greater than the second diameter W2 of the second spray port 211.

The second internal passage 212 may be located inside the body part 210. The second internal passage 212 may connect the second injection port 213 and the second spray port 211. In the embodiment, the second internal passage 212 may extend from the second injection port 213 toward the second spray port 211. The second internal passage 212 may be formed to extend in the first direction D1. In the embodiment, the second internal passage 212 may have a circular cross-sectional shape of which the diameter is reduced as the second internal passage 212 goes closer to the second spray port 211.

The catching part 220 may extend outward from the body part 210. The catching part 220 may be supported by a step of the first nozzle unit 100. Accordingly, the catching part 220 may limit the movement of the second nozzle unit 200 in the first direction D1 so that the second nozzle unit 200 inserted into the first internal passage 120 does not come into contact with the first spray port 110. The catching part 220 may include a sealing groove 221 and a coupling groove 222 recessed toward the second internal passage 212 from the outer surface thereof.

A sealing member (not illustrated) such as an O-ring may be inserted into the sealing groove 221. Accordingly, a gap between the catching part 220 and the first nozzle unit 100 may be sealed. In the embodiment, the sealing groove 221 may be formed along a circumference of the catching part 220. The sealing member may be an O-ring or the like, but the present invention is not limited thereto.

The coupling groove 222 may overlap the coupling hole 150 of the first nozzle unit 100. Accordingly, a coupling member passing through the coupling hole 150 may be inserted into the coupling groove 222. The coupling member passing through the coupling hole 150 can be inserted into the coupling groove 222 to prevent the second nozzle unit 200 from being easily separated from the first internal passage 120 by an external force. The coupling groove 222 may be formed along the circumference of the catching part 220. In the embodiment, the coupling groove 222 may be located between the sealing groove 221 and the second injection port 213.

The second support step 142 may have a step shape recessed from the outer surface of the body part 210 toward the second internal passage 212. The second support step 142 may support one side of the distribution unit 300. For example, the second support step 142 may support a boundary area of a second surface 305 of the distribution unit 300 which will be described below. Accordingly, the second support step 142 together with the first support step 141 can prevent movement of the distribution unit 300.

The distribution unit 300 is located between the first nozzle unit 100 and the second nozzle unit 200. In the embodiment, the distribution unit 300 may be separated from the first nozzle unit 100 and the second nozzle unit 200. Unlike this, in another embodiment, the distribution unit 300 may be formed integrally with at least one of the first nozzle unit 100 and the second nozzle unit 200. The distribution unit 300 may be located inside the first internal passage 120 to partition the first internal passage 120. In the embodiment, the distribution unit 300 partitions the first internal passage 120 into a first partition passage 121 and a second partition passage 122.

The first partition passage 121 is connected to the first spray port 110. The first partition passage 121 may be located from the second partition passage 122 in the first direction D1. The first partition passage 121 is connected to the second spray port 211. For example, a region located at one end of the first partition passage 121 may be located between the first spray port 110 and the second spray port 211. Accordingly, the first spray port 110 and the second spray port 211 are physically separated from each other through the first partition passage 121. As the first partition passage 121 is located between the first spray port 121 and the second spray port 211, a space in which the deposition gas and the plasma may be mixed may be formed. Further, the second partition passage 122 is connected to the first injection port 130.

The distribution unit 300 includes a plurality of connection passages 310 connecting the first partition passage 121 and the second partition passage 122. The distribution unit 300 may include a through-hole 320 through which the second nozzle unit 200 passes.

The distribution unit 300 may include the first surface 303, the second surface 305 facing the first surface 303, an outer surface 301, and an inner surface 302. The first surface 303 may be a surface adjacent to the first spray port 110. The second surface 305 may be a surface adjacent to the insertion port. The first surface 303 may be spaced apart from the second surface 305 in the first direction D1. In the embodiment, the first surface 303 and the second surface 305 may have a circular shape in a plan view, but the present invention is not limited thereto.

The through-hole 320 may pass through the distribution unit 300. In the embodiment, the through-hole 320 may extend from the first surface 303 toward to the second surface 305 and may be connected to the first surface 303 and the second surface 305. In the embodiment, the through-hole 320 may be formed to have a circular shape in a plan view, but the present invention is not limited thereto. The through-hole 320 may be located in the inside from the outer surface 301. The through-hole 320 may be located in a central region of the distribution unit 300. The outer surface 301 may form an outer side of the distribution unit 300, and the inner surface 302 may form an inner surface of the distribution unit 300. The inner surface 302 may surround the through-hole 320.

The connection passages 310 are arranged along a circumference of the distribution unit 300. The connection passages 310 may extend from the first surface 303 toward the second surface 305 to connect the first surface 303 and the second surface 305.

Each of the connection passages 310 is formed as an outer connection groove 310 recessed from the outer surface 301 of the distribution unit 300 toward the through-hole 320.

Each of the connection passages 310 may include an inlet connected to the second partition passage 122 and an outlet connected to the first partition passage 121. The fluid in the second partition passage 122 may flow into the connection passage 310 through in the inlet and may be discharged to the first partition passage 121 through the outlet while spirally flowing along the first partition passage 121.

The outer connection passage 310 are formed to be inclined with respect to a longitudinal direction of the distribution unit 300. In other words, the outer connection passage 310 may extend spirally from the first surface 303 toward the second surface 305. An inclination angle of the outer connection passage 310 may be in a range of 0° to 90° with respect to the longitudinal direction of the distribution unit 300. In the embodiment, the inclination angle may be an angle inclined from the first direction D1 to a third direction D3 perpendicular to the first and second directions D1 and D2. For example, the inclination angle may be about 20° to about 80°, but the present invention is not limited thereto. Further, the inlet of the connection passage 310 may overlap the outlet of the connection passage 310 in the longitudinal direction of the distribution unit 300. Accordingly, interference of the fluid discharged from the connection passages 310 adjacent to each other can be minimized.

In the embodiment, the outer connection passage 310 may have an approximately "U"-shaped cross-sectional shape having a constant width in the longitudinal direction of the distribution unit 300. Since the outer connection passage 310 is formed to be inclined with respect to the longitudinal direction of the distribution unit 300, cross sections of the outer connection passages 310 may be formed to be slightly shifted from each other.

In the embodiment, the width of the outer connection passage 310 is decreased as the outer connection passage 310 goes from the second surface 305 toward the first surface 303. In other words, the width of the outer connection passage 310 is deceased as the outer connection passage 310 goes from the second partition passage 122 to the first partition passage 121. When the width of the outer connection passage 310 is decreased as the outer connection passage 310 goes from the second surface 305 to the first surface 303, a flow rate of the deposition gas in the outer connection passage 310 may be increased toward the first partition passage 121.

Each of the connection passages 310 is formed to be inclined with respect to the longitudinal direction of the distribution unit 300. The deposition gas flowing into the second partition passage 122 through the first injection port 130 may move into the outer connection passage 310. Since the outer connection passage 310 is formed in an oblique direction inclined with respect to the longitudinal direction of the distribution unit 300, the deposition gas passing through the outer connection passage 310 may flow into the first partition passage 121 while rotating. The deposition gas introduced while rotating may be uniformly mixed with the plasma sprayed from the second spray port 211, and a mixture thereof may be sprayed through the first spray port 110.

The fluid supply unit 400 may be connected to the first nozzle unit 100. In the embodiment, the fluid supply unit 400 may be connected to the first injection port 130 of the first nozzle unit 100. Accordingly, the fluid supply unit 400 may inject the fluid to the first internal passage 120 through the first injection port 130.

The plasma supply unit 500 may supply the plasma to the second nozzle unit 200. The plasma supply unit 500 may include a gas supply part for supplying a plasma gas P (for example, air, N₂, O₂, CO₂, Ar, or the like), an electrode member located on a passage through which the plasma gas P is supplied to the second nozzle unit 200, and a power supply part for supplying power to the second nozzle unit 200 and the electrode member. As the power supply part supplies electric power to the second nozzle unit 200 and the electrode member, the plasma gas P may be in a plasma state.

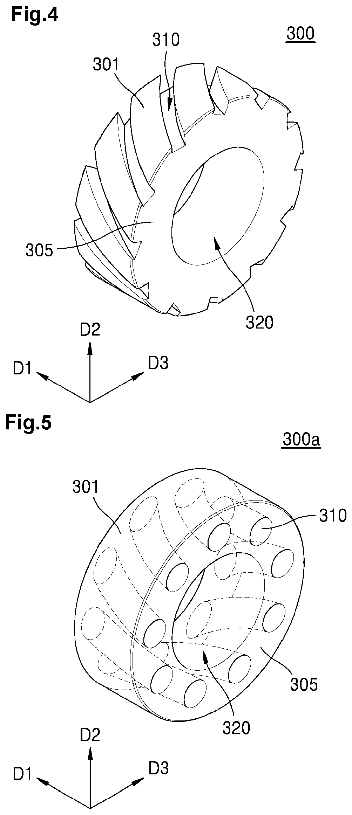

FIGS. 5 to 7 are schematic views illustrating distribution parts according to other embodiments of the present invention. For simplicity of description, the description of the same configuration as that described in FIGS. 1 to 4 will be omitted or briefly described. Further, differences from the configurations of the FIGS. 1 to 4 will be mainly described.

Referring to FIG. 5, a distribution unit 300a not according to the invention may include the through-hole 320, the connection passages 310, the first surface 303, the second surface 305, the outer surface 301, and the inner surface 302. In the distribution unit 300a not according to the invention, each of the connection passages 310 may be formed as the connection hole 310 passing through the distribution unit 300a. The connection holes 310 may be arranged along a circumference of the distribution unit 300a. In the distribution unit 300a not according to the invention, the connection holes 310 may be located between the through-hole 320 and the outer surface 301 of the distribution unit 300a.

Each of the connection holes 310 may be formed to be inclined with respect to the longitudinal direction of the distribution unit 300 and/or the longitudinal direction of the through-hole 320. In other words, each of the connection holes 310 may extend spirally from the first surface 303 toward the second surface 305. In the distribution unit 300a not according to the invention, the connection hole 310 may have a circular cross-sectional shape having a constant diameter in the longitudinal direction of the distribution unit 300a. Since the connection hole 310 is formed to be inclined with respect to the longitudinal direction of the distribution unit 300a, cross sections of the connection holes 310 may be formed to be slightly shifted from each other.

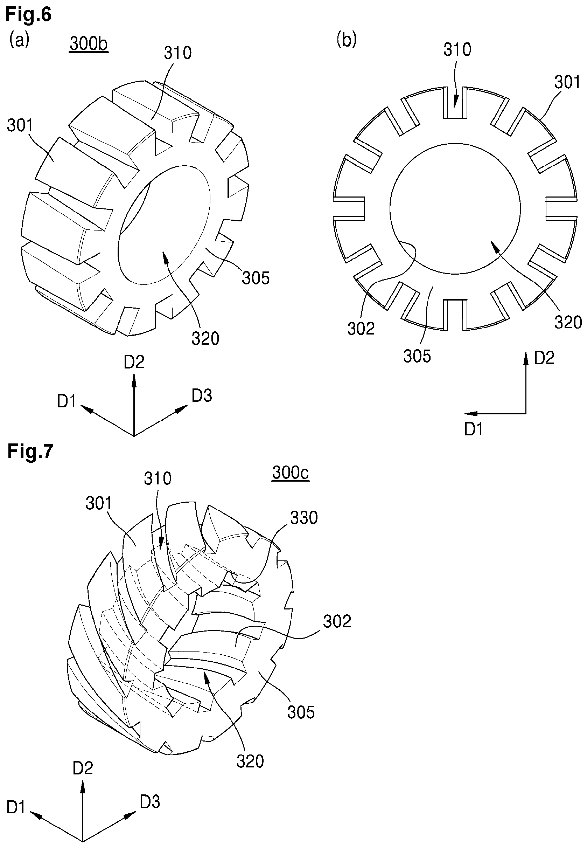

Referring to FIG. 6, a distribution unit 300b may include the through-hole 320, the connection passages 310, the first surface 303, the second surface 305, the outer surface 301, and the inner surface 302. Each of the connection passages 310 is formed as the outer connection groove 310. In the embodiment, unlike the outer connection groove 310 of FIG. 4, the outer connection groove 310 may be parallel to the longitudinal direction of the distribution unit 300b and/or the longitudinal direction of the through-hole 320.

Referring to FIG. 7, a distribution unit 300c may include the through-hole 320, the connection passages 310, the first surface 303, the second surface 305, the outer surface 301, and the inner surface 302. The distribution unit 300c further includes inner connection grooves 330. In the embodiment, each of the connection passages 310 is formed as the outer connection groove 310.

The inner connection grooves 330 are formed to be recessed from the inner surface 302 of the distribution unit 300c toward the outer surface 301 of the distribution unit 300. Accordingly, the inner connection grooves 330 may be connected to the through-hole 320. The inner connection grooves 330 are arranged along the circumference of the distribution unit 300.

The inner connection grooves 330 may each extend from the first surface 303 toward the second surface 305 to connect the first surface 303 and the second surface 305. The inner connection grooves 330 are formed to be inclined with respect to the longitudinal direction of the distribution unit 300c. In other words, each of the inner connection grooves 330 may extend spirally from the first surface 303 toward the second surface 305. Each of the inner connection grooves 330 and each of the outer connection grooves 310 may be located on a virtual line extending radially from a center of the distribution unit 300c. Since the distribution unit 300c includes the inner connection grooves 330 in addition to the connection passages 310, the amount of the deposition gas flowing from a second partition space to the first partition passage 121 may be increased.

An operation of the spray nozzle device 10 according to the present invention will be described below.

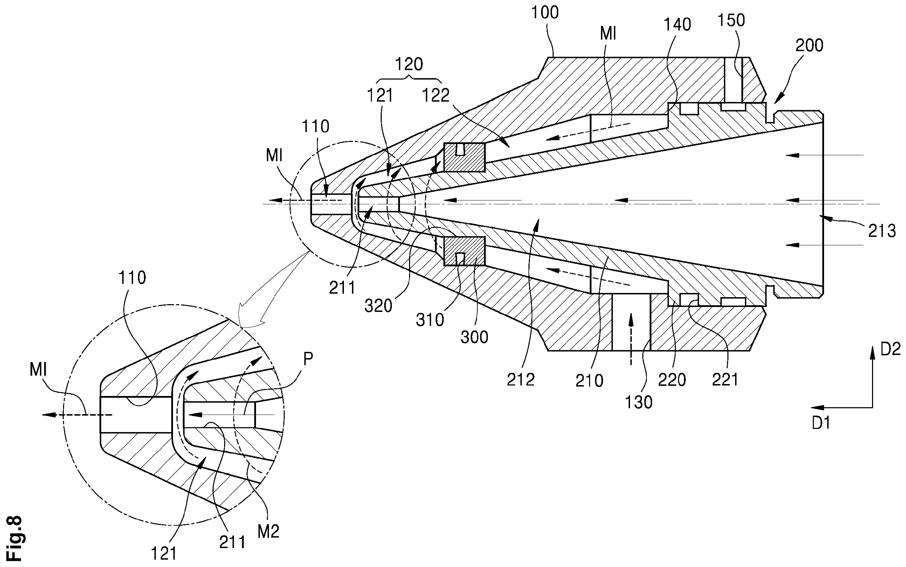

FIG. 8 is a schematic view for describing a state in which a deposition gas is sprayed from the spray nozzle according to the embodiment of the present invention. For simplicity of description, the description of the same configuration as that described in FIGS. 1 to 4 will be omitted or briefly described.

Referring to FIGS. 1 to 4 and 8, a fluid M1 supplied from the fluid supply unit 400 may flow into the second partition passage 122 through the first injection port 130. Further, the plasma gas P supplied from the plasma supply unit 500 may flow into the second internal passage 212 through the second injection port 213. The fluid M1 flowing into the second partition passage 122 may flow toward the distribution unit 300 and may pass through the distribution unit 300 through the connection passages 310 of the distribution unit 300.

Each of the connection passages 310 is formed to be inclined with respect to the longitudinal direction of the distribution unit 300. In other words, each of the connection passages 310 may extend spirally from the second surface 305 toward the first surface 303. Accordingly, the fluid M1 flowing into the connection passages 310 may be rotated while passing through the connection passages 310. For example, a vortex may occur in the fluid M2 passing through the connection passages 310.

The fluid M2 may flow toward the first spray port 110 while rotating. When reaching a space between the first spray port 110 and the second spray port 211, the rotating fluid M2 may be mixed with the plasma gas P sprayed through the second spray port 211. Accordingly, the fluid M1 may be converted into an ionized state and may flow in a spraying direction of the plasma.

As the first spray port 110 and the second spray port 211 are located on the same virtual line, the ionized fluid M1 flowing in a spraying direction of the plasma gas P may be sprayed to the outside of the first nozzle unit 100 through the first spray port 110. The ionized fluid M1 sprayed to the outside of the first nozzle unit 100 may be deposited/applied on the product surface by an electric field or a magnetic field. Accordingly, a coating layer may be formed on the product surface.

## Claims

1. A spray nozzle device (10) comprising:
a first nozzle unit (100) including a first internal passage (120) connected to a first spray port (110) into which a fluid is sprayed and a first injection port (130) through which the fluid is injected to the first internal passage (120);
a second nozzle unit (200) that is located in the first internal passage (120) and has a second spray port (211), through which plasma is sprayed, on one side adjacent to the first spray port (110); and
a distribution unit (300) that is located between the first nozzle unit (100) and the second nozzle unit (200) and partitions the first internal passage (120) into a first partition passage (121) connected to the first spray port (110) and a second partition passage (122) connected to the first injection port (130),
wherein the distribution unit (300) includes a plurality of connection passages (310) connecting the first partition passage (121) and the second partition passage (122),
**characterised in that**
the distribution unit (300) includes inner connection grooves (330) recessed from an inner surface (302) of the distribution unit (300) toward an outer surface (301) of the distribution unit (300),
wherein each of the connection passages (310) is formed as an outer connection groove recessed inward from the outer surface (301) of the distribution unit (300) and has a width that is decreased as the outer connection groove goes from the second partition passage (122) to the first partition passage (121),
wherein the inner connection grooves (330) and the connection passages (310) are formed to be inclined with respect to a longitudinal direction of the distribution unit (300) and are arranged along a circumference of the distribution unit (300),
wherein the second spray port (211) is spaced apart from the first spray port (110) with the first partition passage (121) interposed therebetween,
wherein the first partition passage (121) is connected to the first spray port (110) and to the second spray port (211),
wherein the second spray port (211) is located on the same virtual line as the first spray port (110).

## Patentansprüche

1. Sprühdüsenvorrichtung (10), umfassend:
eine erste Düsenanordnung (100) mit einem ersten Innenkanal (120), der mit einer ersten Sprühöffnung (110), in die ein Fluid gesprüht wird, und einer ersten Einspritzöffnung (130), durch die das Fluid in den ersten Innenkanal (120) eingespritzt wird, verbunden ist;
eine zweite Düseneinheit (200), die sich im ersten Innenkanal (120) befindet und eine zweite Sprühöffnung (211) aufweist, durch die Plasma gesprüht wird, auf einer Seite neben der ersten Sprühöffnung (110); und
eine Verteilereinheit (300), die sich zwischen der ersten Düseneinheit (100) und der zweiten Düseneinheit (200) befindet und den ersten Innenkanal (120) in einen ersten Teilkanal (121), der mit der ersten Sprühöffnung (110) verbunden ist, und einen zweiten Teilkanal (122), der mit der ersten Einspritzöffnung (130) verbunden ist, unterteilt,
wobei die Verteilereinheit (300) mehrere Verbindungskanäle (310) umfasst, die den ersten Teilkanal (121) und den zweiten Teilkanal (122) verbinden,
**dadurch gekennzeichnet, dass**
die Verteilereinheit (300) innere Verbindungsnuten (330) umfasst, die von einer Innenfläche (302) der Verteilereinheit (300) in Richtung einer Außenfläche (301) der Verteilereinheit (300) vertieft sind,
wobei jeder der Verbindungskanäle (310) als eine äußere Verbindungsnut ausgebildet ist, die von der Außenfläche (301) der Verteilungseinheit (300) nach innen vertieft ist und eine Breite aufweist, die sich im Verlauf der äußeren Verbindungsnut vom zweiten Teilkanal (122) zum ersten Teilkanal (121) verringert,
wobei die inneren Verbindungsnuten (330) und die Verbindungskanäle (310) in Bezug auf eine Längsrichtung der Verteilereinheit (300) geneigt ausgebildet und entlang eines Umfangs der Verteilereinheit (300) angeordnet sind,
wobei die zweite Sprühöffnung (211) von der ersten Sprühöffnung (110) beabstandet ist, wobei der erste Teilkanal (121) dazwischen angeordnet ist,
wobei der erste Teilkanal (121) mit der ersten Sprühöffnung (110) und mit der zweiten Sprühöffnung (211) verbunden ist,
wobei sich die zweite Sprühöffnung (211) auf derselben virtuellen Linie wie die erste Sprühöffnung (110) befindet.

## Revendications

1. Un appareil à buse de pulvérisation (10) comprenant :
une première unité de buse (100) comprenant un premier passage interne (120) relié à un premier orifice de pulvérisation (110) dans lequel un fluide est pulvérisé et à un premier orifice d'injection (130) à travers lequel le fluide est injecté dans le premier passage interne (120) ;
une deuxième unité de buse (200) qui est située dans le premier passage interne (120) et comporte un deuxième orifice de pulvérisation (211), à travers lequel du plasma est pulvérisé, sur un côté adjacent au premier orifice de pulvérisation (110) ; et
une unité de distribution (300) qui est située entre la première unité de buse (100) et la deuxième unité de buse (200) et qui divise le premier passage interne (120) en un premier passage partiel (121) relié au premier orifice de pulvérisation (110) et un deuxième passage partiel (122) relié au premier orifice d'injection (130),
l'unité de distribution (300) comprenant une pluralité de passages de connexion (310) reliant le premier passage partiel (121) et le deuxième passage partiel (122), **caractérisée en ce que**
l'unité de distribution (300) comprend des rainures de connexion internes (330) en retrait par rapport à une surface interne (302) de l'unité de distribution (300) vers une surface externe (301) de l'unité de distribution (300),
chacun des passages de connexion (310) étant formé comme une rainure de connexion externe en retrait par rapport à la surface externe (301) de l'unité de distribution (300) vers l'intérieur et ayant une largeur qui diminue à mesure que la rainure de connexion externe va du deuxième passage partiel (122) vers le premier passage partiel (121),
les rainures de connexion intérieures (330) et les passages de connexion (310) étant formés de manière à être inclinés par rapport à une direction longitudinale de l'unité de distribution (300) et étant disposés le long d'une circonférence de l'unité de distribution (300),
le deuxième orifice de pulvérisation (211) étant espacé du premier orifice de pulvérisation (110), le premier passage partiel (121) étant interposé entre eux,
le premier passage partiel (121) étant relié au premier orifice de pulvérisation (110) et au deuxième orifice de pulvérisation (211),
le deuxième orifice de pulvérisation (211) étant situé sur la même ligne virtuelle que le premier orifice de pulvérisation (110).
